# EUROPEAN PATENT APPLICATION

(11) **EP 4 216 433 A1**
(43) Date of publication of application: **26.07.2023**
(21) Application number: 23151032.2
(22) Date of filing: 10.01.2023
(51) Int. Cl.: H03H 3/04, H03H 9/02

(54) **ACOUSTIC WAVE RESONATOR USING MULTILAYER FERROELECTRIC TRANSDUCTION MATERIALS WITH LOW/ZERO COUPLING BORDER REGION**

(30) Priority: 11.01.2022 US 202263298251 P; 29.03.2022 US 202263324968 P; 05.01.2023 US 202318150627
(71) Applicant: Qorvo US, Inc., Greensboro, NC 27409 (US)
(72) Inventor: KOOHI, Milad Zolfagharloo, Longwood, FL (US); TAG, Andreas, Altamonte Springs, FL (US); SCHAEFER, Michael, Mount Dora, FL (US); ROTHEMUND, Ralph, Apokoa, Flordia (US)
(74) Representative: D Young & Co LLP

(57) **Abstract**

The present disclosure relates to a Bulk Acoustic Wave, BAW, resonator (30), which includes a bottom electrode (32), a top electrode (34) structure, and a multilayer transduction structure (36) sandwiched therebetween. Herein, the multilayer transduction structure is composed of multiple transduction layers (41_1, .... 41_N), at least one of which is formed of a ferroelectric material with a box-shape polarization-electric field curve. Each transduction layer includes a transduction border, BO, portion (41_BO_1, ... 41_BO_N) positioned at a periphery of a corresponding transduction layer and a transduction central portion (41_C_1,....41_C_N) surrounded by the transduction BO portion. A combination of all transduction BO portions (41_BO_1, ... 41_BO_N) forms a transduction BO section (40) of the multilayer transduction structure (36), and a combination of all transduction central portions (41_C_1,....41_C_N) forms a transduction central section (36_C) of the multilayer transduction structure (36). An electromechanical coupling coefficient of the transduction BO section is less than an electromechanical coupling coefficient of the transduction central section.

## Description

### Related Applications

This application claims the benefit of provisional patent application serial number 63/298,251, filed January 11, 2022, and provisional patent application serial number 63/324,968, filed March 29, 2022, the disclosures of which are hereby incorporated herein by reference in their entireties.

### Field of the Disclosure

The present disclosure relates to a Bulk Acoustic Wave (BAW) Resonator, which uses multilayer transduction materials, having low or zero electromechanical coupling at a border region of the BAW resonator, and a process for making the same.

### Background

Due to their small size, high Q values, and very low insertion losses at microwave frequencies, particularly those above 1.5 Gigahertz (GHz), Bulk Acoustic Wave (BAW) filters have been widely used in many modern wireless applications. For instance, the BAW filters incorporating BAW resonators are the filter of choice for many 3^{rd} Generation (3G) and 4^{th} Generation (4G) wireless devices, and are destined to dominate filter applications for 5^{th} Generation (5G) wireless devices.

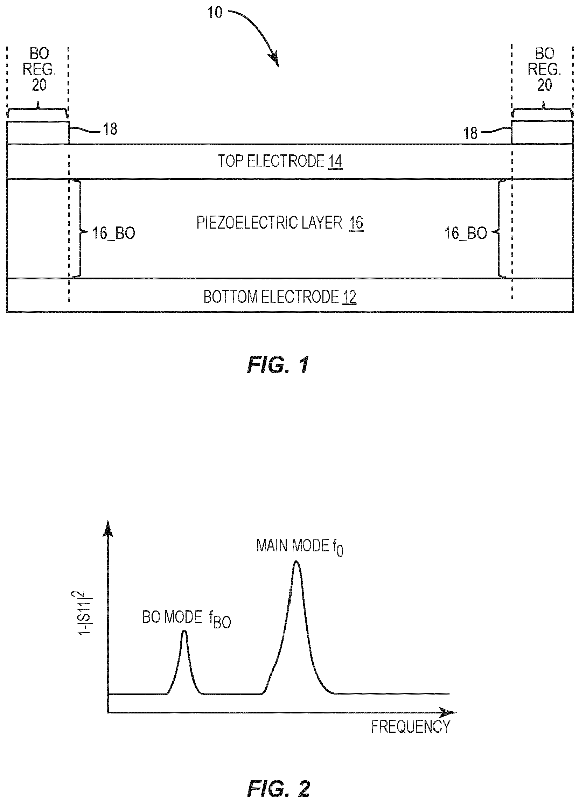

One example of a conventional BAW resonator 10 is illustrated in Figure 1. The BAW resonator 10 includes a bottom electrode 12, a top electrode 14, and a piezoelectric layer 16 (which is sometimes referred to as a transduction layer) sandwiched between the bottom electrode 12 and the top electrode 14. Because of a finite lateral dimension of the BAW resonator 10, lateral wave spurious modes may be excited in the BAW resonator 10, which results in degradation of the quality factor (Q) of the BAW resonator 10. In this regard, a border (BO) ring 18 is introduced to be included in the BAW resonator 10 to confine the energy inside the BAW resonator 10 and prevent the excitation of undesired lateral wave spurious modes. The BO ring 18 is over a top surface of the top electrode 14 around a periphery of the top electrode 14 within what is referred to herein as a BO region 20 of the BAW resonator 10.

Although the BO ring 18 effectively eliminates the lateral wave spurious modes, the BO ring 18 will cause an undesired BO spurious resonance mode near the main resonance of the device. The main cause for the excitation of the BO spurious resonance mode is a nonzero electromechanical coupling coefficient *Kₑ²* of the piezoelectric layer 16 within the BO region 20 (i.e., piezoelectric BO portions 16_BO). Figure 2 shows a typical 1-|S₁₁|² response (1-|S₁₁|² is equal to the power ratio lost in a resonator) of the BAW resonator 10 with the BO ring 18. The frequency difference between the main resonance and the BO spurious resonance mode depends on a thickness and width of the BO ring 18 and the frequency of the main resonance (e.g., less than 100MHz). The undesired BO spurious resonance mode increases the transmission loss of filters that incorporate BAW resonator 10.

### Summary

Particular aspects are set out in the appended independent claims. Various optional embodiments are set out in the dependent claims.

Some approaches described herein may seek to provide BAW resonator designs to reduce or eliminate the BO spurious resonance mode in the BAW resonator, while retaining high Q and low/no lateral wave spurious mode. Further, some approaches described herein may seek to keep the final product cost effective

The present disclosure relates to a Bulk Acoustic Wave (BAW) resonator, which uses multilayer transduction materials, having zero or low electromechanical coupling at a border region of the BAW resonator, and a process for making the same. The disclosed BAW resonator includes a bottom electrode, a top electrode structure, and a multilayer transduction structure sandwiched between the bottom electrode and the top electrode structure. Herein, the multilayer transduction structure is composed of multiple transduction layers, at least one of which is formed of a first ferroelectric material. Polarization of the first ferroelectric material varies with an electric field across the first ferroelectric material. Each transduction layer includes a transduction border portion positioned at a periphery of a corresponding transduction layer and a transduction central portion surrounded by the transduction BO portion. A combination of all transduction BO portions forms a transduction BO section of the multilayer transduction structure, and a combination of all transduction central portions forms a transduction central section of the multilayer transduction structure. A first electromechanical coupling coefficient of the transduction BO section is smaller than a second (non-zero) electromechanical coupling coefficient of the transduction central section. The transduction central section is configured to provide a resonance of the BAW resonator.

In one embodiment of the disclosed BAW resonator, the first electromechanical coupling coefficient of the transduction BO section is a zero electromechanical coupling coefficient.

In one embodiment of the disclosed BAW resonator, the first ferroelectric material used to form the at least one of the transduction layers has a box-shaped polarization-electric field (P-E) curve.

In one embodiment of the disclosed BAW resonator, the first ferroelectric material is scandium aluminum nitride (ScₓAl₁₋ₓN) and the P-E curve of ScₓAl₁₋ₓN is dependent on a scandium concentration x.

In one embodiment of the disclosed BAW resonator, the first ferroelectric material is one of a group consisting of Zirconate Titanate (PZT), Lead titanate (PTO), Hafnium oxide (HfO2), Barium titanate (BTO), and Lithium niobate (LiNbOs).

In one embodiment of the disclosed BAW resonator, at least one of the transduction layers is formed of a second ferroelectric material, which has a different P-E curve compared to the first ferroelectric material.

In one embodiment of the disclosed BAW resonator, at least one of the transduction layers is formed of a piezoelectric material, whose polarization does not vary with an electric field across the piezoelectric material.

In one embodiment of the disclosed BAW resonator, each transduction layer is formed of a different ferroelectric material.

In one embodiment of the disclosed BAW resonator, the top electrode structure includes a top electrode base over the multilayer transduction structure and a BO ring protruding from a periphery of the top electrode base. Herein, a region of the BAW resonator, within which the BO ring is located, is a BO region. The transduction BO section is confined within the BO region and aligned underneath the BO ring, while the transduction central section is not covered by the BO ring.

In one embodiment of the disclosed BAW resonator, each transduction layer has a different thickness.

In one embodiment of the disclosed BAW resonator, each transduction layer has a same thickness.

According to one embodiment, the disclosed BAW resonator further includes a bottom Brag reflector formed underneath the bottom electrode, and a top Brag reflector formed over the top electrode structure.

In one embodiment of the disclosed BAW resonator, the multilayer transduction structure further includes a number of internal electrodes, which are alternated with the transduction layers.

According to an example process, an initial precursor, which includes a bottom electrode, an initial multilayer transduction structure over the bottom electrode, and a bias electrode ring over a periphery of a top surface of the initial multilayer transduction structure, is firstly provided. Herein, a region of the initial precursor within which the bias electrode ring is located is a border (BO) region. The initial multilayer transduction structure is composed of a number of initial transduction layers. At least one of the initial transduction layers is formed of a first ferroelectric material, which has a box-shaped polarization-electric field (P-E) curve. Each of the initial transduction layers includes an initial transduction BO portion, which is confined within the BO region and aligned underneath the bias electrode ring, and a transduction central portion, which is surrounded by the initial transduction BO portion and not covered by the bias electrode ring. A combination of the initial transduction BO portion of each initial transduction layer forms an initial transduction BO section of the initial multilayer transduction structure, and a combination of the transduction central portion of each initial transduction layer forms a transduction central section of the initial multilayer transduction structure. Both the initial transduction BO section and the transduction central section have nonzero electromechanical coupling coefficients. Next, a direct current (DC) bias voltage is applied to the bias electrode ring to convert the initial multilayer transduction structure to a multilayer transduction structure, which includes a transduction BO section converted from the initial transduction BO section and the transduction central section surrounded by the transduction BO section. Herein, the transduction central section remains the nonzero electromechanical coupling coefficient and is configured to provide a resonance of the BAW resonator. The DC bias voltage is selected, such that an overall electromechanical coupling coefficient of the transduction BO section achieves a value less than the nonzero electromechanical coupling coefficient of the transduction central section.

According to one embodiment, the process further includes removing the DC bias voltage, and forming one or more electrode layers over the top surface of the multilayer transduction structure. Herein, the one or more electrode layers extend over the bias electrode ring, and a combination of the one or more electrode layers and the bias electrode ring composes a top electrode structure over the top surface of the multilayer transduction structure.

According to one embodiment, the process further includes removing the DC bias voltage, removing the bias electrode ring to completely expose the top surface of the multilayer transduction structure, and forming a top electrode structure over the top surface of the multilayer transduction structure. The top electrode structure has a flat shape.

In one embodiment of the method, at least one of the transduction layers is formed of a second ferroelectric material, which has a different P-E curve compared to the first ferroelectric material.

In one embodiment of the method, each transduction layer is formed of a different ferroelectric material.

In one embodiment of the method, at least one of the transduction layers is formed of a piezoelectric material, whose polarization does not vary with an electric field across the piezoelectric material.

In one embodiment of the method, the first ferroelectric material is ScₓAl₁₋ₓN and the P-E curve of ScₓAl₁₋ₓN is dependent on a scandium concentration x.

In one embodiment of the method, the first ferroelectric material is one of a group consisting of PZT, PTO, HfO2, BTO, and LiNbOs.

According to an example system with at least one BAW resonator, the system includes a radio-frequency (RF) input circuitry, a RF output circuitry, and a filter circuitry that includes the at least one BAW resonator. Herein, the filter circuitry is connected between the RF input circuitry and the RF output circuitry. The at least one BAW resonator includes a bottom electrode, a top electrode structure, and a multilayer transduction structure sandwiched between the bottom electrode and the top electrode structure. The multilayer transduction structure is composed of multiple transduction layers, at least one of which is formed of a ferroelectric material with a box-shaped P-E curve. Each transduction layer includes a transduction border portion positioned at a periphery of a corresponding transduction layer and a transduction central portion surrounded by the transduction BO portion. A combination of all transduction BO portions forms a transduction BO section of the multilayer transduction structure, and a combination of all transduction central portions forms a transduction central section of the multilayer transduction structure. A first electromechanical coupling coefficient of the transduction BO section is smaller than a second (non-zero) electromechanical coupling coefficient of the transduction central section. The transduction central section is configured to provide a resonance of the BAW resonator.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of the illustrative embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
Figure 1 illustrates a cross-section view of a conventional Bulk Acoustic Wave (BAW) resonator.
Figure 2 illustrates a typical 1-|S₁₁|² response of the BAW resonator shown in Figure 1.
Figure 3A illustrates an example polarization-electric field (P-E) curve of a ferroelectric material.
Figure 3B illustrates example different P-E curves of scandium aluminum nitride (ScAlN) dependency on scandium concentration.
Figure 4 illustrates an example BAW resonator with zero or low electromechanical coupling at a border region according to some embodiments of the present disclosure.
Figures 5A-5C illustrate an example procedure to implement the example BAW resonator shown in Figure 4.
Figures 6A-6B illustrate a 1-|S₁₁|² response of the example BAW resonator shown in Figure 5C.
Figures 7A-7B illustrate another example procedure to implement an alternative BAW resonator according to some embodiments of the present disclosure.
Figures 8-10 illustrate other alternative BAW resonators according to some embodiments of the present disclosure.
Figure 11 illustrates a block diagram of an example system that includes at least one BAW filter which is implemented by one or more BAW resonators.
Figure 12 illustrates a block diagram of example user elements that include at least one BAW filter which is implemented by one or more BAW resonators.

It will be understood that for clear illustrations, Figures 1-12 may not be drawn to scale.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

An electromechanical coupling coefficient *Kₑ²* of a Bulk Acoustic Wave (BAW) resonator, such as a thin film bulk acoustic resonator (FBAR) or a solidly mounted resonator (SMR), is a function of a piezoelectric coefficient d of a transduction layer of the BAW resonator, and the piezoelectric coefficient d is proportional to a polarization P of the transduction layer of the BAW resonator. Therefore, once the polarization P of the transduction layer varies, the piezoelectric coefficient d will change accordingly, and consequently, the electromechanical coupling coefficient *Kₑ²* of the BAW resonator will change as well.

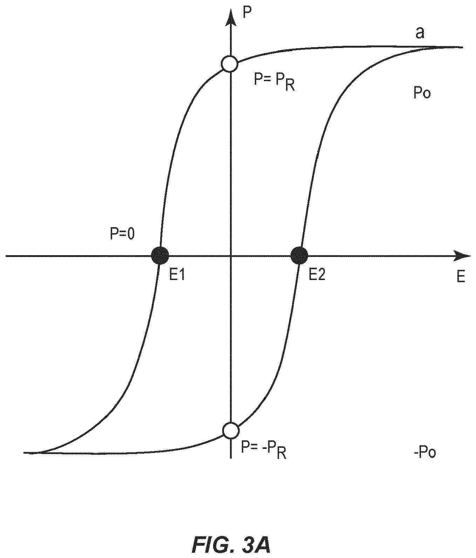

Figure 3A illustrates a simplified polarization-electric field (P-E) curve (i.e., hysteresis loop) of a ferroelectric material (e.g., scandium aluminum nitride). It is clear that the polarization P of the ferroelectric material can be adjusted by changing the electric field E across the ferroelectric material. A variation amount of the polarization P is determined according to a variation amount of the electric field across the ferroelectric material. Herein, changing the electric field across the ferroelectric material may be implemented by applying different direct current (DC) bias voltages to the ferroelectric material. By applying a particular DC bias voltage to the ferroelectric material, the polarization P of the ferroelectric material can achieve a particular value. Each DC bias voltage corresponds to one polarization, depending on a previously applied electric field (i.e., previously applied DC bias voltage). For instance (e.g., moving on a counterclockwise direction), changing the electric field across the ferroelectric material from 0 to E1 (i.e., by applying a particular DC bias voltage to the ferroelectric material), the polarization *P* of the ferroelectric material can be moved from *P*=*P_{R}* to *P*=*0.* As such, the piezoelectric coefficient d of the ferroelectric material can be zero, and the electromechanical coupling coefficient *Kₑ²* of the BAW resonator that utilizes the ferroelectric material in the transduction layer can be zero. In another instance (e.g., moving in a counterclockwise direction), changing the electric field across the ferroelectric material from E1 to 0, the polarization P of the ferroelectric material can be moved from *P*=*0* to *P*= *-P_{R}.*

Notice that, once the polarization P of the ferroelectric material archives a desired value (i.e., the electromechanical coupling coefficient *Kₑ²* achieves a desired value), there is no need to remain the DC bias voltage applied to the ferroelectric material. After removing the DC bias voltage, the polarization *P* of the ferroelectric material (i.e., the electromechanical coupling coefficient *Kₑ²* of the ferroelectric material) will remain at that desired value, until another DC bias voltage is applied to the ferroelectric material.

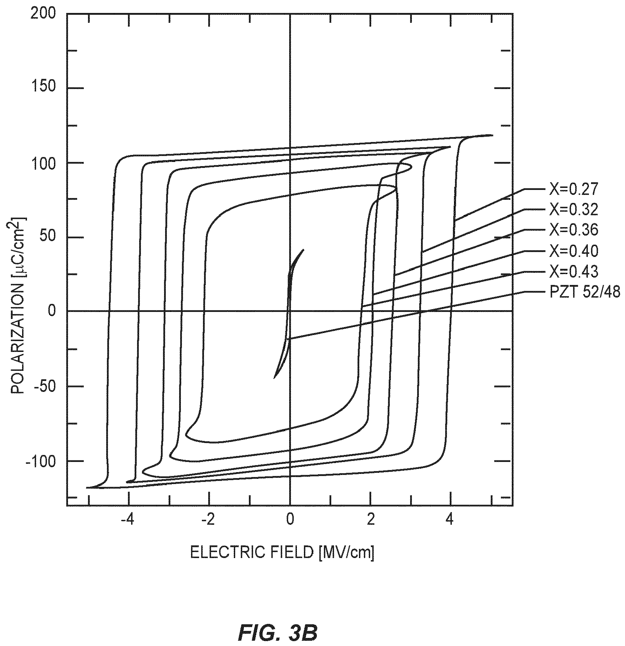

Scandium aluminum nitride (ScₓAl₁₋ₓN) is an example ferroelectric material. Figure 3B illustrates example different P-E curves of ScₓAl₁₋ₓN dependent on a scandium concentration x. When the scandium concentration x=0.27, the electric field E across ScₓAl₁₋ₓN requires -4.5/4 MV/cm to achieve the polarization *P* of ScₓAl₁₋ₓN equal to zero; when the scandium concentration x=0.32, the electric field E across ScₓAl₁₋ₓN requires -3.8/3.3 MV/cm to achieve the polarization *P* of ScₓAl₁₋ₓN equal to zero; when the scandium concentration x=0.36, the electric field E across ScₓAl₁₋ₓN requires -3/2.5 MV/cm to achieve the polarization *P* of ScₓAl₁₋ₓN equal to zero; when the scandium concentration x=0.40, the electric field E across ScₓAl₁₋ₓN requires -2.6/2.1 MV/cm to achieve the polarization *P* of ScₓAl₁₋ₓN equal to zero; and when the scandium concentration x=0.43, the electric field E across ScₓAl₁₋ₓN requires -2.1/1.8 MV/cm to achieve the polarization *P* of ScₓAl₁₋ₓN equal to zero (moving on a counterclockwise direction in the P-E curves). These electric field E values can change and depend on the deposition condition of the ferroelectric material (e.g., ScₓAl₁₋ₓN).

With a same electric field E (applying a same DC bias voltage), the polarization P of ScₓAl₁₋ₓN will have different values and/or different directions due to the scandium concentration x. For instance, when the electric filed E is -1.5 MV/cm, the polarization P of Sc_{0.27}Al_{0.73}N is 105 µC/cm², while the polarization P of Sc_{0.43}Al_{0.57}N is 70 µC/_{cm}². As such, the electromechanical coupling coefficient *Kₑ²* of the ferroelectric material, which is dependent on the polarization *P* of ferroelectric material, may also have different values due to the scandium concentration x.

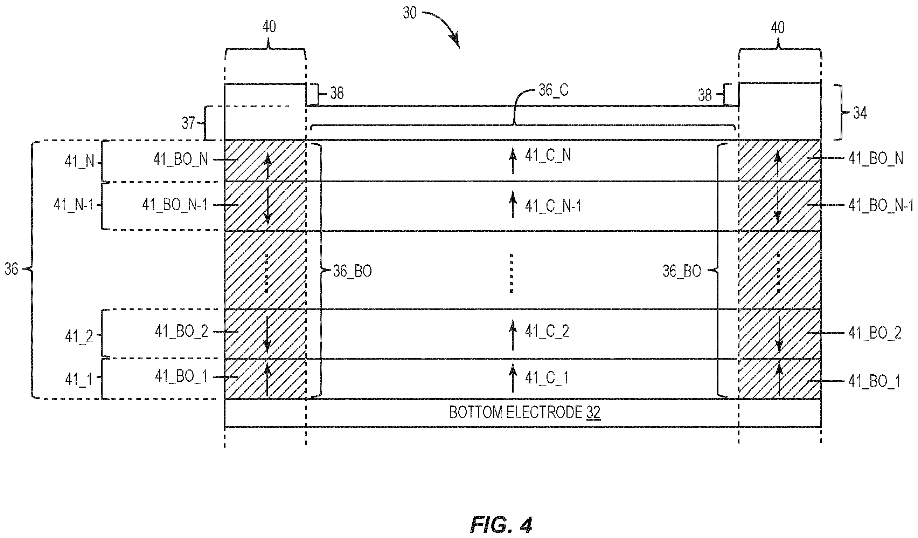

Figure 4 illustrates an example BAW resonator 30 with zero or low electromechanical coupling at a border region according to some embodiments of the present disclosure. The example BAW resonator 30 includes a bottom electrode 32, a top electrode structure 34, and a multilayer transduction structure 36 sandwiched between the bottom electrode 32 and the top electrode structure 34.

In detail, the bottom electrode 32 may be composed of one or more electrode layers (not shown) and includes at least one metal or alloy, such as Tungsten, Aluminum Copper, and the like. The top electrode structure 34 includes a top electrode base 37 over the multilayer transduction structure 36 and a border (BO) ring 38 protruding from a periphery of the top electrode base 37. Notably, a region of the example BAW resonator 30, within which the BO ring 38 is located, is referred to herein as a BO region 40. The top electrode base 37 may be composed of one or more electrode layers (not shown) and includes at least one metal or alloy, such as Tungsten, Aluminum Copper, and the like. The BO ring 38 may be composed of one or more ring layers (not shown) and includes at least one metal or alloy, such as Tungsten, Aluminum Copper, and the like. The bottom electrode 32 and the top electrode base 37 each has a thickness depending on the main resonant frequency of the ferroelectricbased BAW resonator 30. The BO ring 38 is configured to confine the energy inside the example BAW resonator 30 (i.e., inside the multilayer transduction structure 36) and to prevent laterally propagating standing waves.

The multilayer transduction structure 36 includes multiple transduction layers 41 (e.g., as shown in Figure 4, a first transduction layer 41_1 over the bottom electrode 32, a second transduction layer 41_2 over the first transduction layer 41_1, ..... a (N-1)th transduction layer 41_N-1 over the second transduction layer 41_2, a Nth transduction layer 41_N over the (N-1)th transduction layer 41_N-1, and the top electrode structure 34 over the Nth transduction layer 41_N). In some cases, the multilayer transduction structure 36 may only include two transduction layers 41 (i.e., the (N-1)th transduction layer 41_N-1 and the Nth transduction layer 41_N are omitted, and the top electrode structure 34 is over the second transduction layer 41_2). In some cases, the multilayer transduction structure 36 may only include three transduction layers 41 (i.e., N=3, and the (N-1)th transduction layer 41_N-1 and the second transduction layer 41_2 represent a same layer).

Each transduction layer 41 may have a same or different thickness. At least one of the transduction layers 41 is formed of a ferroelectric material, whose polarization will vary with an electric field across the ferroelectric material. For instance, the ferroelectric material used for the at least one of the transduction layers 41 has a box-shaped P-E curve (e.g., as shown in Figure 3A), such as ScₓAl₁₋ₓN, Lead Zirconate Titanate (PZT), Lead titanate (PTO), Hafnium oxide (HfO2), Barium titanate (BTO), Lithium niobate (LiNbOs), or the like.

In one embodiment, some of the transduction layers 41 may be formed of a piezoelectric material (e.g., Aluminum nitride (AlN) and/or Zinc oxide (ZnO)), whose polarization will not vary with an electric field across the piezoelectric material; while the remaining transduction layers 41 may be formed of a ferroelectric material (e.g., ScₓAl₁₋ₓN, PTO, PZT, HfO₂, or BTO), whose polarization will vary with an electric field across the ferroelectric material. Herein, by applying a particular electric field, the polarization of the ferroelectric material may have an opposite direction to the polarization of the piezoelectric material. In one embodiment, the transduction layers 41 formed of the piezoelectric material (e.g., the first transduction layer 41_1...., and the (N-1)th transduction layer 41_N-1) may be alternated with the transduction layers 41 formed of the ferroelectric material (e.g., the second transduction layer 41_2...., and the Nth transduction layer 41_N). In one embodiment, the transduction layers 41 formed of the piezoelectric material may be located in a top region of the multilayer transduction structure 36 and the transduction layers 41 formed of the ferroelectric material may be located in a bottom region of the multilayer transduction structure 36 (not shown). In one embodiment, the transduction layers 41 formed of the piezoelectric material may be located in the bottom region of the multilayer transduction structure 36 and the transduction layers 41 formed of the ferroelectric material may be located in the top region of the multilayer transduction structure 36 (not shown). In one embodiment, the transduction layers 41 formed of the piezoelectric material and the transduction layers 41 formed of the ferroelectric material may be positioned arbitrarily within the multilayer transduction structure 36. The number of the transduction layers 41 formed of the piezoelectric material and the number of the transduction layers 41 formed of the ferroelectric material may be different or the same.

In one embodiment, some of the transduction layers 41 may be formed of one or more piezoelectric materials (e.g., AlN and/or ZnO), while the remaining transduction layers 41 may be formed of two or more ferroelectric materials (e.g., two or more of ScₓAl₁₋ₓN, PTO, PZT, HfO₂, LiNbOs, and BTO), wherein each ferroelectric material has a different P-E curve. When applying a same electric field, a polarization of each different ferroelectric material may have different values and/or directions. In a simplified instance, some of the transduction layers 41 may be formed of a piezoelectric material, some of the transduction layers 41 may be formed of a first ferroelectric material, and some of the transduction layers 41 may be formed of a second ferroelectric material. The first ferroelectric material and the second ferroelectric material have different P-E curves. In one embodiment, upon applying a particular electric field, at least one of the first ferroelectric material and the second ferroelectric material may have a polarization with an opposite direction to the polarization of the piezoelectric material. In one embodiment, upon applying a particular electric field, the first ferroelectric material may have a polarization with an opposite direction to the polarization of the piezoelectric material, while the second ferroelectric material may have a zero polarization. In one embodiment, upon applying a particular electric field, each of the first ferroelectric material and the second ferroelectric material may have a polarization with an opposite direction to the polarization of the piezoelectric material. In one embodiment, the transduction layers 41 formed of different materials may be positioned alternatively. In one embodiment, the transduction layers 41 formed of different materials may be positioned in groups, wherein each group utilizes one material. In one embodiment, the transduction layers 41 formed of different materials may be positioned arbitrarily within the multilayer transduction structure 36. The number of the transduction layers 41 formed of each material may be different or the same.

In one embodiment, none of the transduction layers 41 includes a piezoelectric material, whose polarization will not vary with an electric field across the piezoelectric material. Herein, the transduction layers 41 may be formed of two or more ferroelectric materials, wherein each ferroelectric material has a different P-E curve. When applying a same electric field, a polarization of each different ferroelectric material may have different values and/or directions. In a simplified case, some of the transduction layers 41 may be formed of a first ferroelectric material, while the remaining transduction layers 41 may be formed of a second ferroelectric material. The first ferroelectric material and the second ferroelectric material have different P-E curves. When applying a same electric field, a polarization of the first ferroelectric material may have an opposite direction to a polarization of the second ferroelectric material. For example, the first ferroelectric material is ScₓAl₁₋ₓN and the second ferroelectric material is Sc_{y}Al_{1-y}N, where x is different from y and each of x and y is between 0.1 and 0.8. When the first ferroelectric material is Sc_{0.27}Al_{0.73}N and the second ferroelectric material is Sc_{0.43}Al_{0.57}N, upon changing the electrical field from 0 MV/cm to -2.7 MV/cm (see Figure 3B), the polarization of the first ferroelectric material (positive) has an opposite direction to the polarization of the second ferroelectric material (negative).

In one embodiment, the transduction layers 41 formed of different ferroelectric materials may be positioned alternatively. In one embodiment, the transduction layers 41 formed of different ferroelectric materials may be positioned in groups, wherein each group utilizes one ferroelectric material. In one embodiment, the transduction layers 41 formed of different ferroelectric materials may be positioned arbitrarily within the multilayer transduction structure 36. The number of the transduction layers 41 formed of each ferroelectric material may be different or the same.

In addition, each transduction layer 41 includes a transduction BO portion 41_BO, which is confined within the BO region 40 and is aligned underneath the BO ring 38, and a transduction central portion 41_C surrounded by the corresponding transduction BO portion 41_BO. A combination of all transduction BO portions 41_BO (e.g., a first transduction BO portion 41_BO_1, a second transduction BO portion 41_BO_2,.... a (N-1)th transduction BO portion 41_BO_N-1, and a Nth transduction BO portion 41_BO_N) forms a transduction BO section 36_BO of the multilayer transduction structure 36, wherein the entire transduction BO section 36_BO is confined within the BO region 40 and aligned underneath the BO ring 38. A combination of all transduction central portions 41_C (e.g., a first transduction central portion 41_C_1, a second transduction central portion 41_C_2,.... a (N-1)th transduction central portion 41_C_N-1, and a Nth transduction central portion 41_C_N) forms a transduction central section 36_C of the multilayer transduction structure 36, which is surrounded by the ferroelectric BO portion 36_BO and not covered by the BO ring 38.

Herein, a polarization of each transduction central portion 41_C has a same direction (e.g., the polarization of each transduction central portion 41_C is positive, represented by upward arrows), and thus the transduction central section 36_C has a nonzero electromechanical coupling coefficient *Kₑ²_{NON}* and is configured to provide a main resonance of the example BAW resonator 30 (when an alternating current voltage is applied between the top electrode structure 34 and the bottom electrode 32).

On the other hand, at least one transduction BO portion 41_BO has a positive polarization (e.g., the first transduction BO portion 41_BO_1 of the first transduction layer 41_1 and the Nth transduction BO portion 41_BO_N of the Nth transduction layer 41_N are positive polarizations, represented by upward arrows), and at least one transduction BO portion 41_BO has a negative polarization (e.g., the second transduction BO portion 41_BO_2 of the second transduction layer 41_2 and the (N-1)th transduction BO portion 41_BO_N-1 of the (N-1)th transduction layer 41_N-1 are negative polarization, represented by downward arrows). Optionally, one or more transduction BO portions 41_BO may have a zero polarization (not shown). The polarization of each transduction BO portion 41_BO is configured such that an electromechanical coupling coefficient *Kₑ²_{BO}* of the entire transduction BO section 36_BO is capable of being zero or a value smaller than the nonzero electromechanical coupling coefficient *Kₑ²_{NON}* of the transduction central section 36_C. In consequence, BO spurious resonance mode does not exist near the desired main resonance of the example BAW resonator 30. The zero/small electromechanical coupling coefficient *Kₑ²_{BO}* of the transduction BO section 36_BO will also help confine the energy inside the example BAW resonator 30 and reduce laterally propagating standing waves.

In one embodiment, when some of the transduction layers 41 are formed of the piezoelectric material and the remaining transduction layers 41 are formed of the ferroelectric material, the transduction BO portions 41_BO of these transduction layers 41 formed of the piezoelectric material have an opposite-direction polarization to the transduction BO portions 41_BO of these transduction layers 41 formed of the ferroelectric material. As such, the electromechanical coupling coefficient *Kₑ²_{BO}* of the entire transduction BO section 36_BO may achieve zero/a small value (*Kₑ²_{BO}*) < *Kₑ²_{NON}*)*.*

In one embodiment, when some of the transduction layers 41 are formed of the first ferroelectric material and the remaining transduction layers 41 are formed of the second ferroelectric material, the transduction BO portions 41_BO of these transduction layers 41 formed of the first ferroelectric material have an opposite-direction polarization to the transduction BO portions 41_BO of these transduction layers 41 formed of the second ferroelectric material. As such, the electromechanical coupling coefficient *Kₑ²_{BO}* of the entire transduction BO section 36_BO may achieve zero/a small value (*Kₑ²_{BO}* < *Kₑ²_{NON}*)*.*

In one embodiment, when some of the transduction layers 41 are formed of one or more piezoelectric materials, some of the transduction layers 41 are formed of the first ferroelectric material, and some of the transduction layers 41 are formed of the second ferroelectric material, the transduction BO portions 41_BO of these transduction layers 41 formed of the piezoelectric material have an opposite-direction polarization to the transduction BO portions 41_BO of these transduction layers 41 formed of the first ferroelectric material and/or the second ferroelectric material. As such, the electromechanical coupling coefficient *Kₑ²_{BO}* of the entire transduction BO section 36_BO may achieve zero/a small value (*Kₑ²_{BO}* < *Kₑ²_{NON}*).

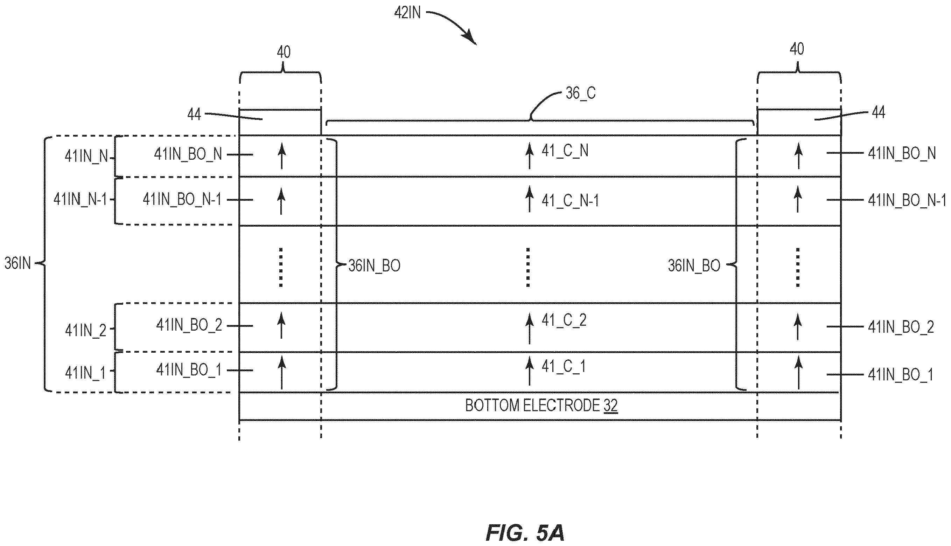

Figures 5A through 5C graphically illustrate an example process for implementing the example BAW resonator 30 shown in Figure 4 according to some embodiments of the present disclosure. Although the process steps are illustrated in a series, the process steps are not necessarily order dependent. Some steps may be done in a different order than that presented, without deviating from the scope of the present disclosure. Further, processes within the scope of this disclosure may include fewer or more steps than those illustrated in Figures 5A-5C.

As illustrated in Figure 5A, the process begins with an initial precursor 42IN, which includes the bottom electrode 32, an initial multilayer transduction structure 36IN over the bottom electrode 32, and a bias electrode ring 44 over a periphery of a top surface of the initial multilayer transduction structure 36IN. Herein, a region of the initial precursor 42IN, within which the bias electrode ring 44 is located, may be referred to the BO region 40. The bias electrode ring 44 may be formed by one or more ring layers (not shown) and includes at least one metal or alloy, such as Tungsten, Aluminum Copper, and the like.

The initial multilayer transduction structure 36IN includes multiple initial transduction layers 41IN (e.g., a first initial transduction layer 41IN_1 over the bottom electrode 32, a second initial transduction layer 41IN_2 over the first initial transduction layer 41IN_1, ..... a (N-1)th initial transduction layer 41IN_N-1 over the second initial transduction layer 41IN_2, a Nth initial transduction layer 41IN_N over the (N-1)th initial transduction layer 41IN_N-1, and the bias electrode ring 44 over the Nth initial transduction layer 41IN_N). In some cases, the initial multilayer transduction structure 36IN may only include two initial transduction layers 41 IN (i.e., the (N-1)th initial transduction layer 41IN_N-1 and the Nth initial transduction layer 41 IN_N are omitted, and the bias electrode ring 44 is over the second initial transduction layer 41IN_2). In some cases, the initial multilayer transduction structure 36IN may only include three initial transduction layers 41 IN (i.e., N=3, and the (N-1)th initial transduction layer 41IN_N-1 and the second initial transduction layer 41IN_2 represent a same layer).

Each initial transduction layer 41IN may have a same or different thickness. At least one of the initial transduction layers 41 IN is formed of a ferroelectric material, whose polarization will vary with an electric field across the ferroelectric material. For instance, the ferroelectric material used for the at least one of the initial transduction layers 41IN has a box-shape P-E curve (e.g., as shown in Figure 3A), such as ScₓAl₁₋ₓN, PTO, PZT, HfO₂, BTO, LiNbOs, or the like. In the initial multilayer transduction structure 36IN, each initial transduction layer 41IN may have a same direction polarization (e.g., a positive polarization, represented by upward arrows).

In one embodiment, some of the initial transduction layers 41IN may be formed of a piezoelectric material (e.g., AlN and/or ZnO), whose polarization will not vary with an electric field across the piezoelectric material; while the remaining initial transduction layers 41IN may be formed of a ferroelectric material (e.g., ScₓAl₁₋ₓN, PTO, PZT, HfO₂, LiNbOs, or BTO), whose polarization will vary with an electric field across the ferroelectric material. Herein, by applying a particular electric field, the polarization of the ferroelectric material may have an opposite direction to the polarization of the piezoelectric material. In one embodiment, the initial transduction layers 41IN formed of the piezoelectric material (e.g., the first initial transduction layer 41IN_1...., and the (N-1)th initial transduction layer 41IN_N-1) may be alternated with the initial transduction layers 41IN formed of the ferroelectric material (e.g., the second initial transduction layer 41IN_2...., and the Nth initial transduction layer 41_N). In one embodiment, the initial transduction layers 41IN formed of the piezoelectric material may be located in a top region of the multilayer transduction structure 36 (e.g., the Nth initial transduction layer 41IN_N, the (N-1)th initial transduction layer 41IN_N-1, and etc..), and the initial transduction layers 41IN formed of the ferroelectric material may be located in a bottom region of the multilayer transduction structure 36 (e.g., the first initial transduction layer 41IN_1, the second initial transduction layer 41IN_2, and etc..). In one embodiment, the initial transduction layers 41IN formed of the piezoelectric material may be located in the bottom region of the multilayer transduction structure 36 (e.g., the first initial transduction layer 41IN_1, the second initial transduction layer 41IN_2, and etc..), and the initial transduction layers 41IN formed of the ferroelectric material may be located in the top region of the multilayer transduction structure 36 (e.g., the Nth initial transduction layer 41IN_N, the (N-1)th initial transduction layer 41IN_N-1, and etc..). In one embodiment, the initial transduction layers 41IN formed of the piezoelectric material and the initial transduction layers 41IN formed of the ferroelectric material may be positioned arbitrarily within the initial multilayer transduction structure 36IN. The number of the initial transduction layers 41IN formed of the piezoelectric material and the number of the initial transduction layers 41IN formed of the ferroelectric material may be different or the same.

In one embodiment, none of the initial transduction layers 41IN includes a piezoelectric material, whose polarization will not vary with an electric field across the piezoelectric material. Herein, the initial transduction layers 41IN may be formed of two or more ferroelectric materials (e.g., ScₓAl₁₋ₓN, PTO, PZT, HfO₂, LiNbOs, and/or BTO), wherein each ferroelectric material has a different P-E curve. When applying a same electric field, a polarization of each different ferroelectric material may have different values and/or directions. In a simplified case, some of the initial transduction layers 41 IN may be formed of a first ferroelectric material, while the remaining initial transduction layers 41IN may be formed of a second ferroelectric material. The first ferroelectric material and the second ferroelectric material have different P-E curves, where upon applying a same electric field, a polarization of the first ferroelectric material may have an opposite direction to a polarization of the second ferroelectric material. In one embodiment, the initial transduction layers 41IN formed of different ferroelectric materials may be positioned in an alternative configuration, a grouped configuration, or an arbitrary configuration. The number of the initial transduction layers 41 IN formed of each ferroelectric material may be different or the same.

In one embodiment, some of the initial transduction layers 41 IN may be formed of one or more piezoelectric materials (e.g., AlN and/or ZnO), while the remaining initial transduction layers 41 IN may be formed of two or more ferroelectric materials (e.g., ScₓAl₁₋ₓN, PTO, PZT, HfO₂, LiNbOs and/or BTO), wherein each ferroelectric material has a different P-E curve. In a simplified instance, some of the initial transduction layers 41IN may be formed of a piezoelectric material, some of the initial transduction layers 41IN may be formed of a first ferroelectric material, and some of the initial transduction layers 41 IN may be formed of a second ferroelectric material. The first ferroelectric material and the second ferroelectric material have different P-E curves. In one embodiment, upon applying a particular electric field, at least one of the first ferroelectric material and the second ferroelectric material may have a polarization with an opposite direction to the polarization of the piezoelectric material. In one embodiment, upon applying a particular electric field, the first ferroelectric material may have a polarization with an opposite direction to the polarization of the piezoelectric material, while the second ferroelectric material may have a zero polarization. In one embodiment, upon applying a particular electric field, each of the first ferroelectric material and the second ferroelectric material may have a polarization with an opposite direction to the polarization of the piezoelectric material. The initial transduction layers 41IN formed of different materials may be positioned in an alternative configuration, a grouped configuration, or an arbitrary configuration. The number of the initial transduction layers 41IN formed of each material may be different or the same.

In addition, each initial transduction layer 41 IN includes an initial transduction BO portion 41IN_BO (e.g., a first initial transduction BO portion 41IN_BO_1, a second initial transduction BO portion 41IN_BO_2,... a (N-1)th initial transduction BO portion 41IN_BO_N-1, and a Nth initial transduction BO portion 41IN_BO_N, respectively), which is confined within the BO region 40 and aligned underneath the bias electrode ring 44. A combination of all initial transduction BO portions 41IN_BO forms an initial transduction BO section 36IN_BO of the initial multilayer transduction structure 36IN, where the entire initial transduction BO section 36IN_BO is confined within the BO region 40 and aligned underneath the bias electrode ring 44.

Besides the initial transduction BO section 36IN_BO, the initial multilayer transduction structure 36IN also includes the transduction central section 36_C, which is surrounded by the initial transduction BO section 36IN_BO and not covered by the bias electrode ring 44. The transduction central section 36_C is a combination of a transduction central portion 41_C of each initial transduction layer 41IN, where the transduction central portion 41_C of each initial transduction layer 41IN is surrounded by a corresponding initial transduction BO portion 41IN_BO. Notice that each entire initial transduction layer 41IN, including the corresponding initial transduction BO portion 41IN_BO and the corresponding transduction central portion 41_C, has a non-zero polarization (e.g., with a same positive direction, represented by upward arrows). As such, both the transduction central section 36_C and the initial transduction BO section 36IN_BO have non-zero electromechanical coupling coefficients, and consequently, a main resonance and a BO spurious resonance (near a main resonance) will exist in the initial precursor 42IN.

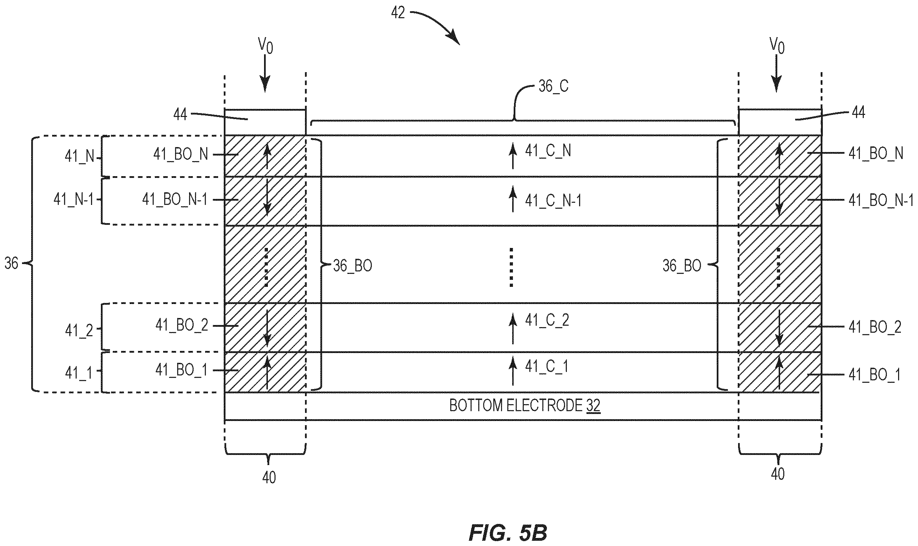

Next, a DC bias voltage V₀ is applied to the bias electrode ring 44, and the bottom electrode 32 is electrically coupled to ground, such that the initial multilayer transduction structure 36IN converts to the multilayer transduction structure 36 with the zero/small-electromechanical-coupling transduction BO section 36_BO (the initial precursor 42IN converts to a precursor 42), as illustrated in Figure 5B. The multilayer transduction structure 36 is composed of the first transduction layer 41_1, the second transduction layer 41_2, .... the (N-1)th transduction layer 41_N-1, and the Nth transduction layer 41_N. Each transduction layer 41 is transformed from a corresponding initial transduction layer 41IN and has a same central portion 41_C as the corresponding initial transduction layer 41 IN.

The DC bias voltage V₀ changes the electric field between the bias electrode ring 44 and the bottom electrode 32 (i.e., the electric field across the initial transduction BO section 36IN_BO), but barely changes the electric field across the transduction central section 36_C. When some initial transduction layers 41 IN are formed of one or more piezoelectric material (e.g., AlN and/or ZnO), whose polarization will not vary with the electric field across the piezoelectric material, the corresponding transduction layers 41 will have no change from these initial transduction layer 41IN. For instance, the first initial transduction layer 41IN_1 and the Nth initial transduction layer 41IN_N are formed of one piezoelectric material. After applying the DC bias voltage V₀, the first transduction layer 41_1 and the Nth transduction layer 41_N have no change from the first initial transduction layer 41 IN_1 and the Nth initial transduction layer 41 IN_N, respectively.

When some initial transduction layers 41IN are formed of one ferroelectric material (e.g., ScₓAl₁₋ₓN, PTO, PZT, HfO₂, LiNbOs, or BTO), whose polarization will vary with an electric field across the ferroelectric material, after applying the DC bias voltage V₀, the polarization of the transduction BO portions 41_BO (underneath the bias electrode ring 44, where the DC bias voltage V₀ is applied) of the corresponding transduction layers 41 may be different from the polarization of the initial transduction BO portions 41IN_BO of these initial transduction layers 41IN. For instance, the second initial transduction layer 41IN_2 and the (N-1)th initial transduction layer 41IN_N-1 are formed of one ferroelectric material. After applying the DC bias voltage V₀, the polarization of the second transduction BO portion 41_BO_2 of the second transduction layer 41_2 may have an opposite direction (e.g., negative, represented by a downward arrow) to the polarization of the second initial transduction BO portion 41IN_BO_2 of the second initial transduction layer 41IN_2 and the polarization of the (N-1)th transduction BO portion 41_BO_N-1 of the (N-1)th transduction layer 41_N-1 may have an opposite direction (e.g., negative, represented by a downward arrow) to the polarization of the (N-1)th initial transduction BO portion 41IN_BO_N-1 of the (N-1)th initial transduction layer 41IN_N-1. Notice that the polarization of each transduction central portion 41_C does not change, because the DC bias voltage V₀ is not applied across the transduction central section 36_C.

When some initial transduction layers 41 IN are formed of two or more ferroelectric materials with different P-E curves (e.g., two or more of ScₓAl₁₋ₓN, PTO, PZT, HfO₂, LiNbOs, and BTO), after applying the DC bias voltage V₀, the transduction BO portions 41_BO of the corresponding transduction layers 41 may have different polarization variations. For instance, the second initial transduction layer 41IN_2 is formed of a first ferroelectric material, and the (N-1)th initial transduction layer 41IN_N-1 is formed of a second ferroelectric material. After applying the DC bias voltage V₀, the polarization of the second transduction BO portion 41_BO_2 of the second transduction layer 41_2 and the polarization of the (N-1)th transduction BO portion 41_BO_N-1 of the (N-1)th transduction layer 41_N-1 are reversed in direction, but with different values. In another case, after applying the DC bias voltage V₀, the polarization of the second transduction BO portion 41_BO_2 of the second transduction layer 41_2 is reversed in direction, while the polarization of the (N-1)th transduction BO portion 41_BO_N-1 of the (N-1)th transduction layer 41_N-1 is zero (not shown).

Herein, the material used to form each initial transduction layer 41IN and the DC bias voltage V₀ are carefully selected, such that after applying the DC bias voltage V₀ to the bias electrode ring 44, the polarizations of some transduction BO portions 41_BO remain the initial direction and the polarizations of some other transduction BO portions 41_BO are reversed in direction. Consequently, an overall electromechanical coupling coefficient *Kₑ²_{BO}* of the transduction BO section 36_BO can achieve zero or a value smaller than a nonzero electromechanical coupling coefficient *Kₑ²_{NON}* of the transduction central section 36_C. The DC bias voltage V₀ is selected based on the material used for each initial transduction layer 41 IN and the thickness of each initial transduction layer 41IN.

Notice that, once the polarization *P* of each transduction BO portion 41_BO achieves a desired value, there is no need to retain the DC bias voltage V₀ applied across the transduction BO section 36_BO. After removing the DC bias voltage V₀, the polarization *P* of each transduction BO portion 41_BO will remain the same, until another DC bias voltage is applied across the transduction BO section 36_BO.

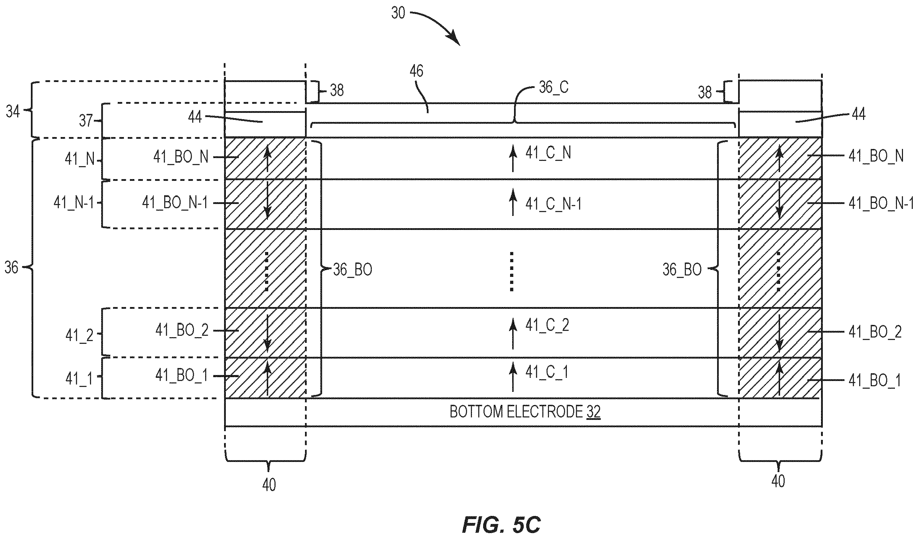

After removing the DC bias voltage V₀, one or more electrode layers 46 are formed over the top surface of the multilayer transduction structure 36, as illustrated in Figure 5C. The one or more electrode layers 46 extend over the bias electrode ring 44, and a combination of the one or more electrode layers 46 and the bias electrode ring 44 composes the top electrode structure 34. From shape aspects, the top electrode structure 34 includes the top electrode base 37 over the multilayer transduction structure 36 and the BO ring 38 protruding from the periphery of the top electrode base 37. The BO region 40 is the region within which the BO ring 38 is located. The one or more electrode layers 46 includes at least one metal or alloy, such as Tungsten, Aluminum Copper, and the like.

Notice that a thickness of the bias electrode ring 44 and a thickness of the BO ring 38 may be different or the same. In a desired case, a width of the bias electrode ring 44 and a width of the BO ring 38 may be the same. However, in some applications, the width of the bias electrode ring 44 and the width of the BO ring 38 may be different.

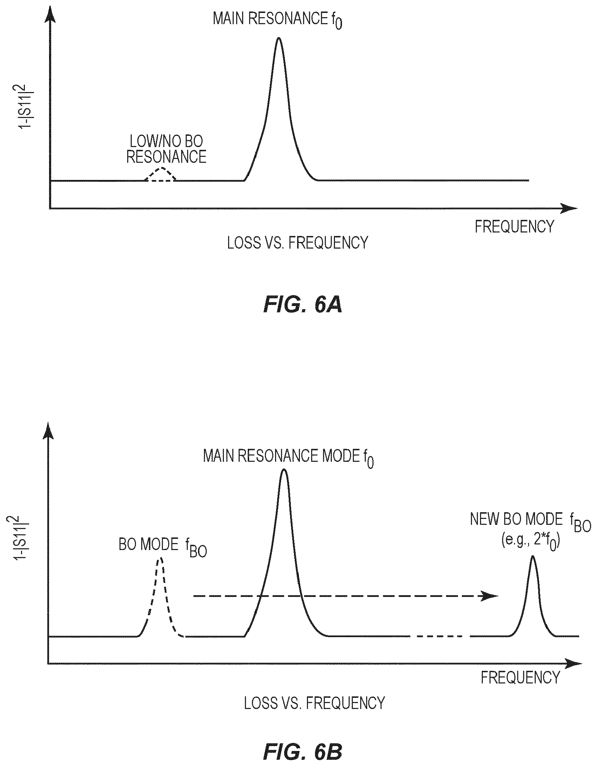

Figures 6A and 6B show a 1-|S₁₁|² response (1-|S₁₁|² is equal to the power ratio lost in a resonator) of the example BAW resonator 30. Depending on the materials used in the multilayer transduction structure 36, the undesired BO spurious resonance (which is caused by the nonzero electromechanical coupling coefficient *Kₑ²* in the initial transduction BO section 36IN_BO) near the main resonance of the example BAW resonator 30 is eliminated/significantly compressed (see Figure 6A), or shifts far away from the main resonance of the example BAW resonator 30 (e.g., at twice the frequency of the main resonance, see Figure 6B). The main resonance of the example BAW resonator 30 is barely affected by the nonzero electromechanical coupling transduction BO section 36_BO.

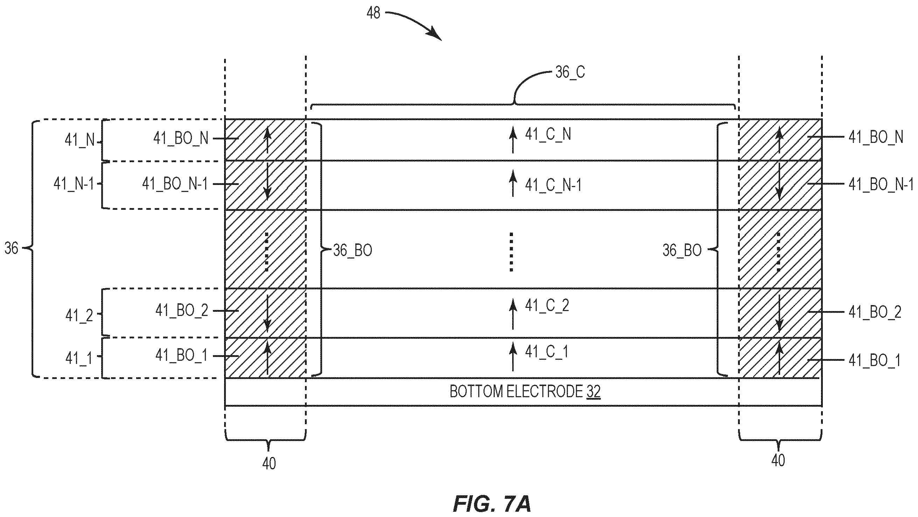

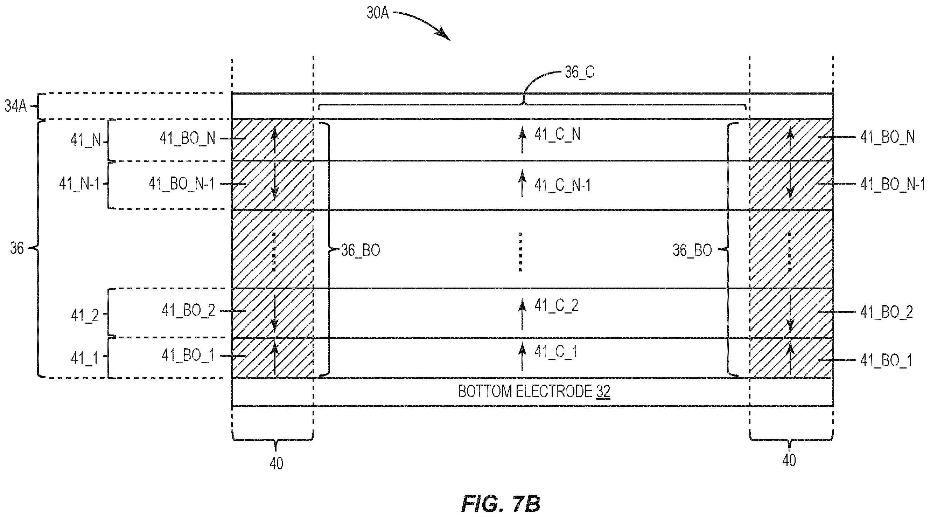

Figures 7A-7B illustrate another example procedure to implement an alternative BAW resonator according to some embodiments of the present disclosure. After removing the DC bias voltage V₀, the bias electrode ring 44 may be removed to form an alternative precursor 48, as illustrated in Figure 7A. Herein, the electromechanical coupling coefficient *Kₑ²_{BO}* in the transduction BO section 36_BO remains at zero or the small value. Next, an alternative top electrode structure 34A is applied over the top surface of the multilayer transduction structure 36 to complete an alternative BAW resonator 30A, as illustrated in Figure 7B. The alternative top electrode structure 34A has a flat shape. The alternative top electrode structure 34A may be composed of one or more electrode layers (not shown) and includes at least one metal or alloy, such as Tungsten, Aluminum Copper, and the like.

Due to the zero/small electromechanical coupling coefficient *Kₑ²_{BO}* of the transduction BO section 36_BO, the undesired BO spurious resonance mode does not exist near the main resonance of the alternative BAW resonator 30A. Furthermore, even without the BO ring structure, the zero/small electromechanical coupling coefficient *Kₑ²_{BO}* of the transduction BO section 36_BO will help confine the energy inside the alternative BAW resonator 30A and reduce laterally propagating waves. The transduction central portion 36_C in the alternative BAW resonator 30A still has a nonzero electromechanical coupling coefficient *Kₑ²_{NON}* (larger than the electromechanical coupling coefficient *Kₑ²_{BO}* of the entire transduction BO section 36_BO), and is configured to provide the main resonance of the alternative BAW resonator 30A (when an alternating current voltage is applied between the alternative top electrode structure 34A and the bottom electrode 32).

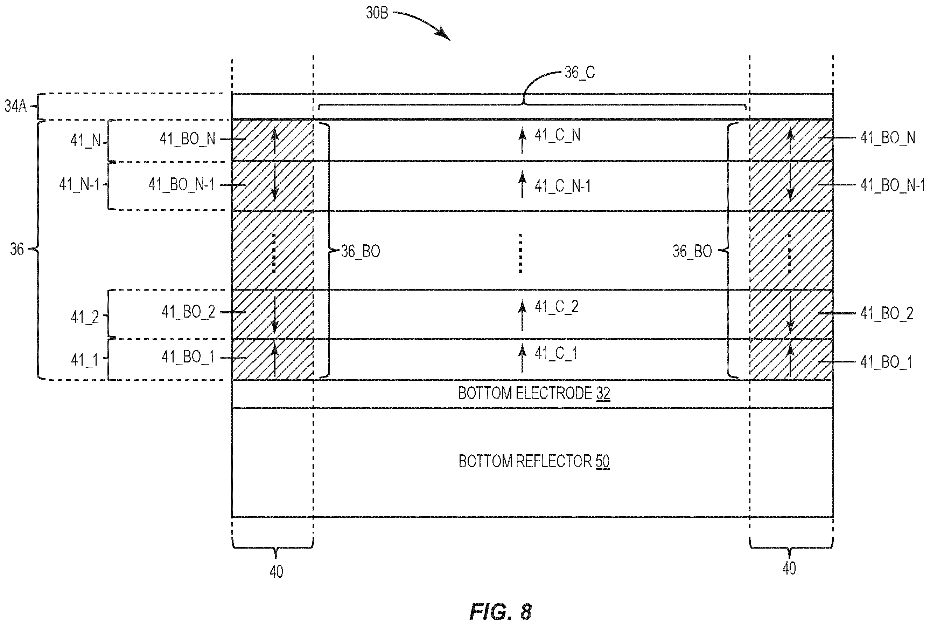

In some applications, a BAW resonator may further include one or two reflectors. Figure 8 illustrates a second alternative BAW resonator 30B, wherein in addition to the bottom electrode 32, the alternative top electrode structure 34A, and the multilayer transduction structure 36, the second alternative BAW resonator 30B also includes a bottom reflector 50 underneath the bottom electrode 32. The bottom reflector 50 may be a Brag reflector. In some applications, the second alternative BAW resonator 30B may include the top electrode structure 34 (as shown in Figure 4 or 6C) instead of the alternative top electrode structure 34A over the multilayer transduction structure 36 (not shown).

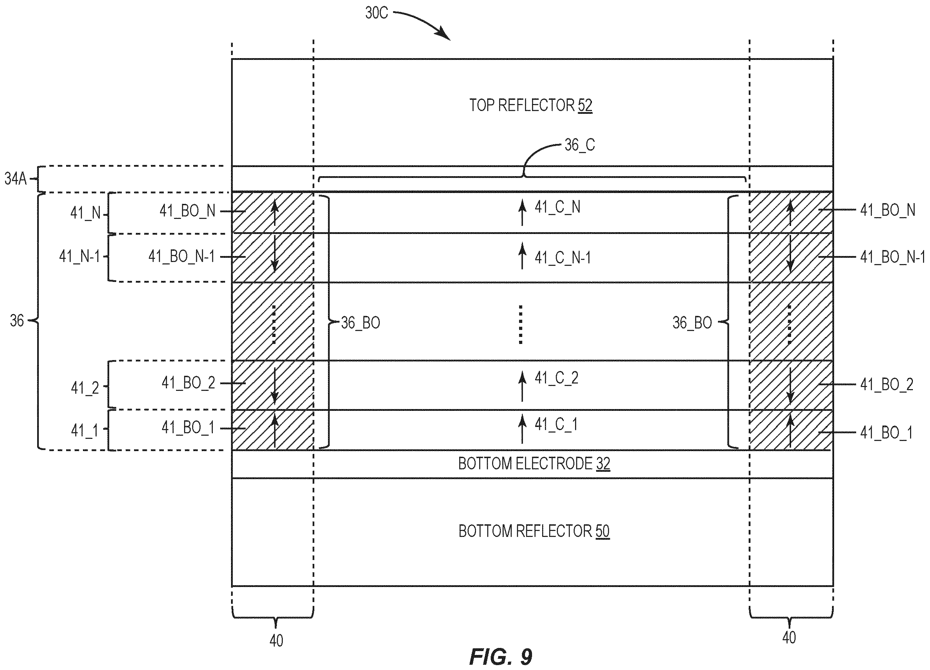

As illustrated in Figure 9, a third alternative BAW resonator 30C, in addition to the bottom electrode 32, the alternative top electrode structure 34A, and the multilayer transduction structure 36, also includes the bottom reflector 50 underneath the bottom electrode 32 and a top reflector 52 over the alternative top electrode structure 34A. The bottom reflector 50 and the top reflector 52 may be Brag reflectors. In some applications, the third alternative BAW resonator 30C may include the top electrode structure 34 (as shown in Figure 4 or 6C) instead of the alternative top electrode structure 34A sandwiched between the multilayer transduction structure 36 and the top reflector 52 (not shown).

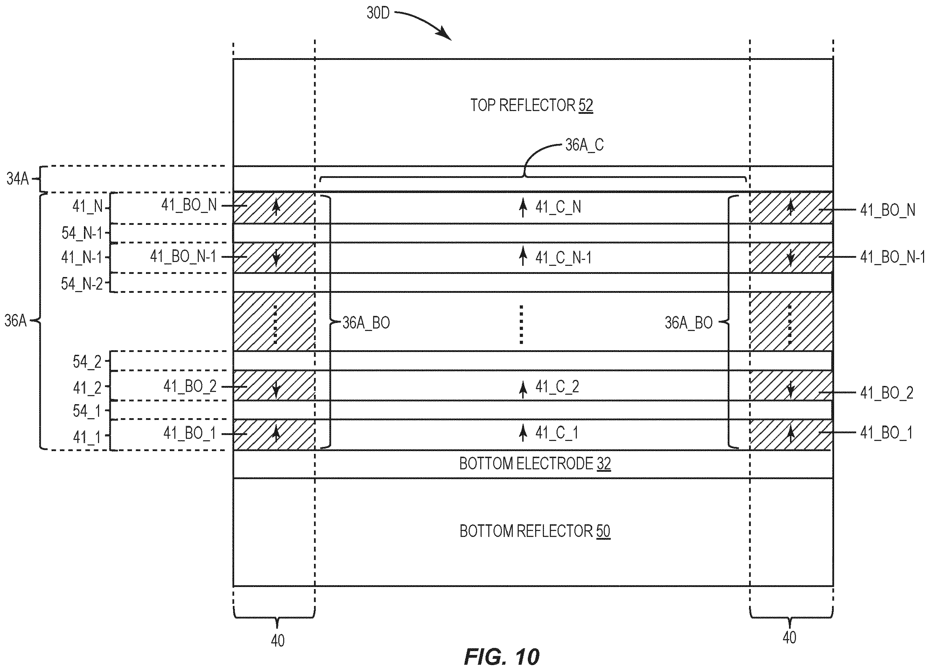

In some applications, in order to adjust the electric field across each transduction layer, internal electrodes may be used. As illustrated in Figure 10, a fourth alternative BAW resonator 30D includes an alternative multilayer transduction structure 36A between the bottom electrode 32 and the alternative top electrode structure 34A. Herein, the alternative multilayer transduction structure 36A, in addition to the multiple transduction layers 41, also includes multiple internal electrodes 54, which are alternated with the transduction layers 41 (e.g., a first internal electrode 54_1 is over the first transduction layer 41_1, the second transduction layer 41_2 is over the first internal electrode 54_1, a second internal electrode 54_2 is over the second transduction layer 41_2,..... the (N-1)th transduction layer 41_N-1 is over a (N-2)th internal electrode 54_N-2, a (N-1)th internal electrode 54_N-1 is over the (N-1)th transduction layer 41_N-1, and the Nth transduction layer 41_N is over the (N-1)th internal electrode 54_N-1). Each internal electrode 54 may be composed of one or more electrode layers (not shown) and includes at least one metal or alloy, such as Tungsten, Aluminum Copper, and the like.

From functionality aspects, the alternative multilayer transduction structure 36A is composed of an alternative transduction BO section 36A_BO at the periphery of the alternative multilayer transduction structure 36A and an alternative transduction central section 36A_C surrounded by the alternative transduction BO section 36A_BO. The alternative transduction central section 36A_C has a nonzero electromechanical coupling coefficient, and is configured to provide a main resonance of the fourth alternative BAW resonator 30D (when an alternating current voltage is applied between the top electrode structure 34 and the bottom electrode 32). The alternative transduction BO section 36A_BO has a zero/small electromechanical coupling coefficient (smaller than the nonzero electromechanical coupling coefficient of the alternative transduction central section 36A_C), and thus the undesired BO spurious resonance does not exist or exists far away from the main resonance of the fourth alternative BAW resonator 30D.

In some applications, the fourth alternative BAW resonator 30D may include the top electrode structure 34 (as shown in Figure 4 or 6C) instead of the alternative top electrode structure 34A (not shown). In some applications, the fourth alternative BAW resonator 30D may further include the bottom reflector 50 and/or the top reflector 52.

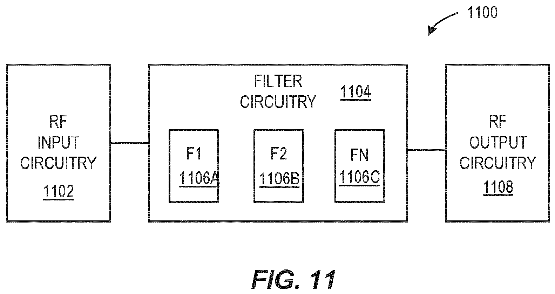

Figure 11 illustrates a block diagram of an example system 1100 that includes at least one BAW filter, which is implemented by one or more BAW resonators 30/30A/30B/30C/30D as shown in Figures 4, 7B, 8, 9, and 10, respectively. The system 1100 includes RF input circuitry 1102 connected to filter circuitry 1104. In certain embodiments, the RF input circuitry 1102 includes a transceiver.

For the purpose of this illustration, the filter circuitry 1104 includes three filters 1106A, 1106B, and 1106C. Herein, one or more of the filters 1106A, 1106B, and 1106C may be BAW filters, which are implemented by one or more BAW resonators 30/30A/30B/30C/30D. In different applications, the filter circuitry 1104 may include more or fewer filters. In one embodiment, each of the filters 1106A, 1106B, and 1106C may be a lowpass filter or a bandpass filter, and the filters 1106A, 1106B, and 1106C may be connected in a cascaded arrangement. The filter types that are included in the filter circuitry 1104 may be based at least on the rejection requirements of the system 1100.

The filter circuitry 1104 is connected to an RF output circuitry 1108. In certain embodiments, the RF output circuitry 1108 includes an antenna. The RF input circuitry 1102 and/or the RF output circuitry 1108 may include additional or different components in other embodiments.

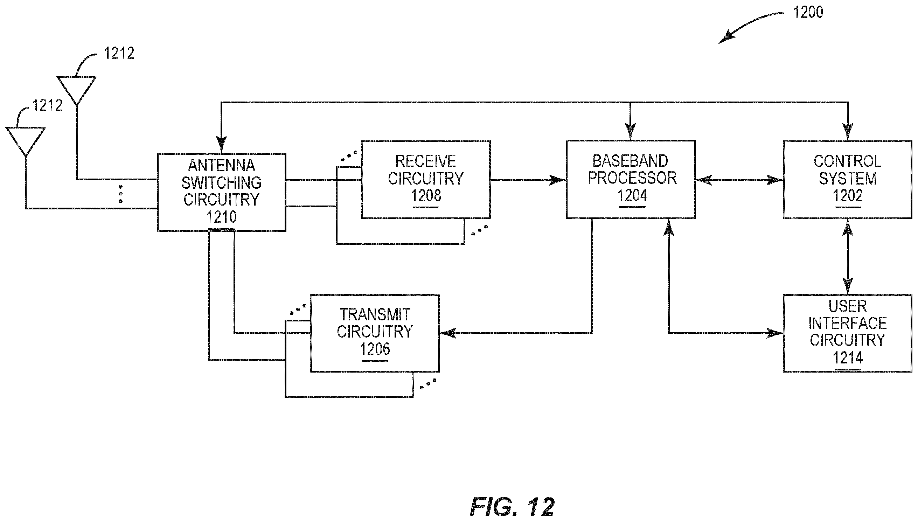

Figure 12 illustrates a block diagram of example user elements that include at least one BAW filter, which is implemented by one or more BAW resonators 30/30A/30B/30C/30D shown in Figures 4, 7B, 8, 9, and 10, respectively. The concepts described above may be implemented in various types of user elements 1200, such as mobile terminals, smart watches, tablets, computers, navigation devices, access points, and like wireless communication devices that support wireless communications, such as cellular, wireless local area network (WLAN), BLUETOOTH, and near field communications. The user elements 1200 will generally include a control system 1202, a baseband processor 1204, transmit circuitry 1206, receive circuitry 1208, antenna switching circuitry 1210, multiple antennas 1212, and user interface circuitry 1214. In a non-limiting example, the control system 1202 can be a field-programmable gate array (FPGA) or an application-specific integrated circuit (ASIC), as an example. In this regard, the control system 1202 can include at least a microprocessor(s), an embedded memory circuit(s), and a communication bus interface(s). The receive circuitry 1208 receives radio frequency signals via the antennas 1212 and through the antenna switching circuitry 1210 from one or more base stations. A low noise amplifier and a filter of the receive circuitry 1208 cooperate to amplify and remove broadband interference from the received signal for processing. Down conversion and digitization circuitry (not shown) will then down convert the filtered, received signal to an intermediate or baseband frequency signal, which is then digitized into one or more digital streams using analog-to-digital converter(s) (ADC).

The baseband processor 1204 processes the digitized received signal to extract the information or data bits conveyed in the received signal. This processing typically comprises demodulation, decoding, and error correction operations, as will be discussed in greater detail below. The baseband processor 1204 is generally implemented in one or more digital signal processors (DSPs) and ASICs.

For transmission, the baseband processor 1204 receives digitized data, which may represent voice, data, or control information, from the control system 1202, which it encodes for transmission. The encoded data is output to the transmit circuitry 1206, where a digital-to-analog converter(s) (DAC) converts the digitally encoded data into an analog signal and a modulator modulates the analog signal onto a carrier signal that is at a desired transmit frequency or frequencies. A power amplifier will amplify the modulated carrier signal to a level appropriate for transmission and deliver the modulated carrier signal to the antennas 1212 through the antenna switching circuitry 1210 to the antennas 1212. The multiple antennas 1212 and the replicated transmit and receive circuitries 1206, 1208 may provide spatial diversity. Modulation and processing details will be understood by those skilled in the art.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illlustrative embodiments of the present disclosure. All such improvements and modifications are considered within the scope of the concepts disclosed herein and the claims that follow.

Therefore from one perspective there have been describes approaches for a Bulk Acoustic Wave (BAW) resonator, which includes a bottom electrode, a top electrode structure, and a multilayer transduction structure sandwiched therebetween. Herein, the multilayer transduction structure is composed of multiple transduction layers, at least one of which is formed of a ferroelectric material with a box-shape polarization-electric field curve. Each transduction layer includes a transduction border (BO) portion positioned at a periphery of a corresponding transduction layer and a transduction central portion surrounded by the transduction BO portion. A combination of all transduction BO portions forms a transduction BO section of the multilayer transduction structure, and a combination of all transduction central portions forms a transduction central section of the multilayer transduction structure. An electromechanical coupling coefficient of the transduction BO section is less than an electromechanical coupling coefficient of the transduction central section.

Further examples are set out in the following numbered clauses:
Clause 1. A Bulk Acoustic Wave, BAW, resonator, comprising: a bottom electrode; a top electrode structure; and a multilayer transduction structure sandwiched between the bottom electrode and the top electrode structure, wherein: the multilayer transduction structure is composed of a plurality of transduction layers; at least one of the plurality of transduction layers is formed of a first ferroelectric material, whose polarization varies with an electric field across the first ferroelectric material; each of the plurality of transduction layers includes a transduction border, BO, portion positioned at a periphery of a corresponding transduction layer and a transduction central portion surrounded by the transduction BO portion, wherein a combination of the transduction BO portion of each of the plurality of transduction layers forms a transduction BO section of the multilayer transduction structure, and a combination of the transduction central portion of each of the plurality of transduction layers forms a transduction central section of the multilayer transduction structure; and the transduction BO section has a first electromechanical coupling coefficient, and the transduction central section has a second electromechanical coupling coefficient, which is larger than the first electromechanical coupling coefficient of the transduction BO section, wherein the transduction central section is configured to provide a resonance of the BAW resonator.
Clause 2. The BAW resonator of clause 1 wherein the first electromechanical coupling coefficient of the transduction BO section is a zero electromechanical coupling coefficient.
Clause 3. The BAW resonator of clause 1 or 2 wherein the first ferroelectric material used to form the at least one of the plurality of transduction layers has a box-shaped polarization-electric field, P-E, curve.
Clause 4. The BAW resonator of clause 3 wherein the first ferroelectric material is scandium aluminum nitride, ScxAl1-xN, and the P-E curve of ScxAl1-xN is dependent on a scandium concentration x.
Clause 5. The BAW resonator of clause 3 wherein the first ferroelectric material is one of a group consisting of Zirconate Titanate (PZT), Lead titanate (PTO), Hafnium oxide (HfO2), Barium titanate (BTO), Lithium niobate (LiNbO3).
Clause 6. The BAW resonator of clause 3, 4 or 5 wherein at least one of the plurality of transduction layers is formed of a second ferroelectric material, which has a different P-E curve compared to the first ferroelectric material.
Clause 7. The BAW resonator of clause 6 wherein at least one of the plurality of transduction layers is formed of a piezoelectric material, whose polarization does not vary with an electric field across the piezoelectric material.
Clause 8. The BAW resonator of any preceding clause wherein each of the plurality of transduction layers is formed of a different ferroelectric material.
Clause 9. The BAW resonator of any preceding clause wherein at least one of the plurality of transduction layers is formed of a piezoelectric material, whose polarization does not vary with an electric field across the piezoelectric material.
Clause 10. The BAW resonator of any preceding clause wherein the top electrode structure comprises a top electrode base over the multilayer transduction structure and a BO ring protruding from a periphery of the top electrode base, wherein: a region of the BAW resonator within which the BO ring is located is a BO region; and the transduction BO section is confined within the BO region and aligned underneath the BO ring, while the transduction central section is not covered by the BO ring.
Clause 11. The BAW resonator of any preceding clause wherein each of the plurality of transduction layers has a different thickness.
Clause 12. The BAW resonator of any preceding clause wherein each of the plurality of transduction layers has a same thickness.
Clause 13. The BAW resonator of any preceding clause further comprising a bottom Brag reflector formed underneath the bottom electrode.
Clause 14. The BAW resonator of clause 13 further comprising a top Brag reflector formed over the top electrode structure.
Clause 15. The BAW resonator of any preceding clause wherein the multilayer transduction structure further comprises a plurality of internal electrodes, which are alternated with the plurality of transduction layers.
Clause 16. A method of implementing a Bulk Acoustic Wave, BAW, resonator, comprising: providing an initial precursor, which includes a bottom electrode, an initial multilayer transduction structure over the bottom electrode, and a bias electrode ring over a periphery of a top surface of the initial multilayer transduction structure, wherein: a region of the initial precursor within which the bias electrode ring is located is a border, BO, region; the initial multilayer transduction structure is composed of a plurality of initial transduction layers; at least one of the plurality of initial transduction layers is formed of a first ferroelectric material, which has a box-shaped polarization-electric field, P-E, curve; each of the plurality of initial transduction layers includes an initial transduction BO portion, which is confined within the BO region and aligned underneath the bias electrode ring, and a transduction central portion, which is surrounded by the initial transduction BO portion and not covered by the bias electrode ring; a combination of the initial transduction BO portion of each of the plurality of initial transduction layers forms an initial transduction BO section of the initial multilayer transduction structure, and a combination of the transduction central portion of each of the plurality of initial transduction layers forms a transduction central section of the initial multilayer transduction structure; and both the initial transduction BO section and the transduction central section have nonzero electromechanical coupling coefficients; applying a direct current, DC, bias voltage to the bias electrode ring to convert the initial multilayer transduction structure to a multilayer transduction structure, which includes a transduction BO section converted from the initial transduction BO section and the transduction central section surrounded by the transduction BO section, wherein: the transduction central section remains the nonzero electromechanical coupling coefficient, and is configured to provide a resonance of the BAW resonator; and the DC bias voltage is selected, such that an overall electromechanical coupling coefficient of the transduction BO section achieves a value less than the nonzero electromechanical coupling coefficient of the transduction central section.
Clause 17 The method of clause 16 further comprising: removing the DC bias voltage; and forming one or more electrode layers over the top surface of the multilayer transduction structure, wherein the one or more electrode layers extend over the bias electrode ring, and a combination of the one or more electrode layers and the bias electrode ring composes a top electrode structure over the top surface of the multilayer transduction structure.
Clause 18. The method of clause 16 further comprising: removing the DC bias voltage; removing the bias electrode ring to completely expose the top surface of the multilayer transduction structure; and forming a top electrode structure over the top surface of the multilayer transduction structure, wherein the top electrode structure has a flat shape.
Clause 19. The method of clause 16, 17 or 18 wherein at least one of the plurality of transduction layers is formed of a second ferroelectric material, which has a different P-E curve compared to the first ferroelectric material.
Clause 20. The method of any of clauses 16 to 19 wherein each of the plurality of transduction layers is formed of a different ferroelectric material.
Clause 21. The method of any of clauses 16 to 20 wherein at least one of the plurality of transduction layers is formed of a piezoelectric material, whose polarization does not vary with an electric field across the piezoelectric material.
Clause 22. The method of any of clauses 16 to 21 wherein the first ferroelectric material is scandium aluminum nitride (ScxAl1-xN) and the P-E curve of ScxAl1-xN is dependent on a scandium concentration x.
Clause 23. The method of any of clauses 16 to 21 wherein the first ferroelectric material is one of a group consisting of Zirconate Titanate, PZT, Lead titanate, PTO, Hafnium oxide, HfO2, Barium titanate, BTO, Lithium niobate, LiNbO3.
Clause 24. A system, comprising: a radio-frequency, RF, input circuitry; a RF output circuitry; and a filter circuitry, which includes at least one Bulk Acoustic Wave, BAW, resonator, connected between the RF input circuitry and the RF output circuitry, wherein the at least one BAW resonator comprises: a bottom electrode; a top electrode structure; and a multilayer transduction structure sandwiched between the bottom electrode and the top electrode structure, wherein: the multilayer transduction structure is composed of a plurality of transduction layers; at least one of the plurality of transduction layers is formed of a ferroelectric material, which has a box-shaped polarization-electric field, P-E, curve; each of the plurality of transduction layers includes a transduction border (BO) portion positioned at a periphery of a corresponding transduction layer and a transduction central portion surrounded by the transduction BO portion, wherein a combination of the transduction BO portion of each of the plurality of transduction layers forms a transduction BO section of the multilayer transduction structure, and a combination of the transduction central portion of each of the plurality of transduction layers forms a transduction central section of the multilayer transduction structure; and the transduction BO section has a first electromechanical coupling coefficient, and the transduction central section has a second electromechanical coupling coefficient, which is larger than the first electromechanical coupling coefficient of the transduction BO section, wherein the transduction central section is configured to provide a resonance of the BAW resonator.

## Claims

1. A Bulk Acoustic Wave, BAW, resonator, comprising:
a bottom electrode;
a top electrode structure; and
a multilayer transduction structure sandwiched between the bottom electrode and the top electrode structure, wherein:
the multilayer transduction structure is composed of a plurality of transduction layers;
at least one of the plurality of transduction layers is formed of a first ferroelectric material, whose polarization varies with an electric field across the first ferroelectric material;
each of the plurality of transduction layers includes a transduction border, BO, portion positioned at a periphery of a corresponding transduction layer and a transduction central portion surrounded by the transduction BO portion, wherein a combination of the transduction BO portion of each of the plurality of transduction layers forms a transduction BO section of the multilayer transduction structure, and a combination of the transduction central portion of each of the plurality of transduction layers forms a transduction central section of the multilayer transduction structure; and
the transduction BO section has a first electromechanical coupling coefficient, and the transduction central section has a second electromechanical coupling coefficient, which is larger than the first electromechanical coupling coefficient of the transduction BO section, wherein the transduction central section is configured to provide a resonance of the BAW resonator.

2. The BAW resonator of claim 1 wherein the first electromechanical coupling coefficient of the transduction BO section is a zero electromechanical coupling coefficient.

3. The BAW resonator of claim 1 or 2 wherein the first ferroelectric material used to form the at least one of the plurality of transduction layers has a box-shaped polarization-electric field, P-E, curve.

4. The BAW resonator of claim 3 wherein the first ferroelectric material is scandium aluminum nitride, ScₓAl₁₋ₓN, and the P-E curve of ScₓAl₁₋ₓN is dependent on a scandium concentration x.

5. The BAW resonator of claim 3 wherein the first ferroelectric material is one of a group consisting of Zirconate Titanate, PZT, Lead titanate, PTO, Hafnium oxide, HfO2, Barium titanate, BTO, Lithium niobate, LiNbOs.

6. The BAW resonator of claim 3, 4 or 5 wherein at least one of the plurality of transduction layers is formed of a second ferroelectric material, which has a different P-E curve compared to the first ferroelectric material, and for example, wherein at least one of the plurality of transduction layers is formed of a piezoelectric material, whose polarization does not vary with an electric field across the piezoelectric material.

7. The BAW resonator of any preceding claim wherein each of the plurality of transduction layers is formed of a different ferroelectric material.

8. The BAW resonator of any preceding claim wherein at least one of the plurality of transduction layers is formed of a piezoelectric material, whose polarization does not vary with an electric field across the piezoelectric material.

9. The BAW resonator of any preceding claim wherein the top electrode structure comprises a top electrode base over the multilayer transduction structure and a BO ring protruding from a periphery of the top electrode base, wherein:
a region of the BAW resonator within which the BO ring is located is a BO region; and
the transduction BO section is confined within the BO region and aligned underneath the BO ring, while the transduction central section is not covered by the BO ring.

10. The BAW resonator of any preceding claim wherein each of the plurality of transduction layers has a thickness selected from the group comprising: a different thickness; and a same thickness.

11. The BAW resonator of any preceding claim wherein the multilayer transduction structure further comprises a plurality of internal electrodes, which are alternated with the plurality of transduction layers.

12. A system, comprising:
a radio-frequency, RF, input circuitry;
a RF output circuitry; and
a filter circuitry, which includes at least one Bulk Acoustic Wave, BAW, resonator, according to any preceding claim, connected between the RF input circuitry and the RF output circuitry.

13. A method of implementing a Bulk Acoustic Wave, BAW, resonator, comprising:
providing an initial precursor, which includes a bottom electrode, an initial multilayer transduction structure over the bottom electrode, and a bias electrode ring over a periphery of a top surface of the initial multilayer transduction structure, wherein:
a region of the initial precursor within which the bias electrode ring is located is a border, BO, region;
the initial multilayer transduction structure is composed of a plurality of initial transduction layers;
at least one of the plurality of initial transduction layers is formed of a first ferroelectric material, which has a box-shaped polarization-electric field, P-E, curve;
each of the plurality of initial transduction layers includes an initial transduction BO portion, which is confined within the BO region and aligned underneath the bias electrode ring, and a transduction central portion, which is surrounded by the initial transduction BO portion and not covered by the bias electrode ring;
a combination of the initial transduction BO portion of each of the plurality of initial transduction layers forms an initial transduction BO section of the initial multilayer transduction structure, and a combination of the transduction central portion of each of the plurality of initial transduction layers forms a transduction central section of the initial multilayer transduction structure; and
both the initial transduction BO section and the transduction central section have nonzero electromechanical coupling coefficients;
applying a direct current, DC, bias voltage to the bias electrode ring to convert the initial multilayer transduction structure to a multilayer transduction structure, which includes a transduction BO section converted from the initial transduction BO section and the transduction central section surrounded by the transduction BO section, wherein:
the transduction central section remains the nonzero electromechanical coupling coefficient, and is configured to provide a resonance of the BAW resonator; and
the DC bias voltage is selected, such that an overall electromechanical coupling coefficient of the transduction BO section achieves a value less than the nonzero electromechanical coupling coefficient of the transduction central section.

14. The method of claim 13 further comprising:
removing the DC bias voltage; and
one selected from the group comprising:
forming one or more electrode layers over the top surface of the multilayer transduction structure, wherein the one or more electrode layers extend over the bias electrode ring, and a combination of the one or more electrode layers and the bias electrode ring composes a top electrode structure over the top surface of the multilayer transduction structure; and
removing the bias electrode ring to completely expose the top surface of the multilayer transduction structure, and forming a top electrode structure over the top surface of the multilayer transduction structure, wherein the top electrode structure has a flat shape.

15. The method of claim 13 or 14 further comprising implementing the BAW resonator to have the functionality of any of claims 2 to 11.
